# EUROPEAN PATENT APPLICATION

(11) **EP 4 542 622 A1**
(43) Date of publication of application: **23.04.2025**
(21) Application number: 22946896.2
(22) Date of filing: 17.06.2022

(54) **METHOD FOR PRODUCING JOSEPHSON JUNCTION ELEMENT AND METHOD FOR PRODUCING QUANTUM BIT**

(71) Applicant: FUJITSU LIMITED, Kawasaki-shi, Kanagawa 211-8588 (JP)
(72) Inventor: TAKAHASHI, Tsuyoshi, Kawasaki-shi, Kanagawa 211-8588 (JP)
(74) Representative: Hoffmann Eitle
(86) International application number: PCT/JP2022/024327
(87) International publication number: WO 2023/243080

(57) **Abstract**

A method for manufacturing a Josephson junction device, includes: forming, on a substrate, a mask layer where mask patterns are arranged in a first direction, each pattern having a first opening extending in the first direction and a second opening extending in a second direction intersecting the first direction and the first opening; forming, using the mask layer, a first film by first film formation from obliquely above in the first direction, and then forming a second film by second film formation from obliquely above in a direction different from the first film formation, and forming a superconducting film including the first and second films; forming an insulating film on the superconducting film; and forming a third film overlapping the superconducting film via the insulating film by third film formation from obliquely above in the second direction, and forming another superconducting film including the third film.

## Description

### FIELD

The present invention relates to a method for manufacturing a Josephson junction device and a method for manufacturing a qubit.

### BACKGROUND

A qubit including a transmon in which a Josephson junction device and a capacitor are coupled in parallel is known. The Josephson junction device has a structure in which an insulating film is sandwiched between two layers of superconducting films. It is known that the superconducting film is formed by film formation from an oblique direction (for example, Patent Documents 1 and 2). In a case where the superconducting film is formed by the film formation from the oblique direction, a difference in a width dimension of a plurality of the superconducting films formed above a substrate may occur due to a difference in an incident angle of a film formation material to an opening of a mask layer. Thus, it is known that the width dimension of the plurality of superconducting films formed above the substrate is made substantially the same even in a case where the incident angle of the film formation material is different by correcting a width dimension of the opening of the mask layer (for example, Patent Document 3).

### SUMMARY

### TECHNICAL PROBLEM

When the Josephson junction device is manufactured, a mask layer provided with a plurality of mask patterns each having a first opening and a second opening extending in an intersecting manner may be used. In this case, a first superconducting film is formed by film formation from obliquely above in a direction in which the first opening extends, an insulating film is formed on a surface of the first superconducting film, and then a second superconducting film is formed by film formation from obliquely above in a direction in which the second opening extends. However, in such a method, variation in a width dimension of a plurality of the second superconducting films formed above a substrate may increase.

In one aspect, an object is to suppress variation in a width dimension of a second superconducting film small.

### SOLUTION TO PROBLEM

In one aspect, a method for manufacturing a Josephson junction device includes: forming, on a substrate, a mask layer in which a plurality of mask patterns, each of which has a first opening that extends in a first direction and a second opening that extends in a second direction that intersects the first direction and that intersects the first opening, is arranged in the first direction; forming, using the mask layer as a mask, a first film above the substrate by first film formation from obliquely above in the first direction, and forming, after the forming the first film, a second film above the substrate by second film formation from obliquely above in a direction different from the direction of the first film formation relative to the substrate, and forming a first superconducting film that includes the first film and the second film; forming an insulating film on a surface of the first superconducting film; and forming, using the mask layer as a mask, a third film that has a region in which the third film overlaps the first superconducting film via the insulating film above the substrate by third film formation from obliquely above in the second direction, and forming a second superconducting film that includes the third film.

In one aspect, a method for manufacturing a qubit includes: forming a Josephson junction device; and forming a capacitor coupled in parallel to the Josephson junction device, and the forming the Josephson junction device includes: forming, on a substrate, a mask layer in which a plurality of mask patterns, each of which has a first opening that extends in a first direction and a second opening that extends in a second direction that intersects the first direction and that intersects the first opening, is arranged in the first direction; forming, using the mask layer as a mask, a first film above the substrate by first film formation from obliquely above in the first direction, and forming, after the forming the first film, a second film above the substrate by second film formation from obliquely above in a direction different from the direction of the first film formation relative to the substrate, and forming a first superconducting film that includes the first film and the second film; forming an insulating film on a surface of the first superconducting film; and forming, using the mask layer as a mask, a third film that has a region in which the third film overlaps the first superconducting film via the insulating film above the substrate by third film formation from obliquely above in the second direction, and forming a second superconducting film that includes the third film.

### ADVANTAGEOUS EFFECTS OF INVENTION

As one aspect, it is possible to suppress variation in a width dimension of a second superconducting film small.

### BRIEF DESCRIPTION OF DRAWINGS

FIGs. 1A to 1C are views (part 1) illustrating a method for manufacturing a Josephson junction device according to a comparative example.
FIGs. 2A and 2B are views (part 2) illustrating the method for manufacturing the Josephson junction device according to the comparative example.
FIGs. 3A and 3B are diagrams illustrating an oblique vacuum deposition method for film formation of a first superconducting film in the manufacturing method of the comparative example.
FIGs. 4A to 4C are views illustrating a film thickness distribution of the first superconducting film in the manufacturing method of the comparative example.
FIGs. 5A to 5C are views illustrating a width distribution of a second superconducting film in the manufacturing method of the comparative example.
FIGs. 6A to 6C are views (part 1) illustrating a method for manufacturing a Josephson junction device according to a first embodiment.
FIGs. 7A to 7C are views (part 2) illustrating the method for manufacturing the Josephson junction device according to the first embodiment.
FIGs. 8A to 8C are views (part 3) illustrating the method for manufacturing the Josephson junction device according to the first embodiment.
FIGs. 9A to 9C are views (part 4) illustrating the method for manufacturing the Josephson junction device according to the first embodiment.
FIGs. 10A to 10C are views (part 5) illustrating the method for manufacturing the Josephson junction device according to the first embodiment.
FIGs. 11A to 11C are views (part 6) illustrating the method for manufacturing the Josephson junction device according to the first embodiment.
FIG. 12A is a plan view after film formation of a first film of a first superconducting film, and FIG. 12B is a plan view after film formation of a second film of the first superconducting film.
FIGs. 13A and 13B are diagrams illustrating an oblique vacuum deposition method for film formation of the first superconducting film in the manufacturing method of the first embodiment.
FIG. 14A is a schematic diagram illustrating the width distribution of the second superconducting film in the manufacturing method of the comparative example, and FIG. 14B is a schematic diagram illustrating a width distribution of a second superconducting film in the manufacturing method of the first embodiment.
FIGs. 15A to 15C are cross-sectional views illustrating a method for manufacturing a Josephson junction device according to a second embodiment.
FIGs. 16A and 16B are diagrams illustrating an incident angle of a deposition material to a substrate in an oblique vacuum deposition method for film formation of a first superconducting film and a second superconducting film.
FIGs. 17A to 17I are views illustrating incident angles of the deposition material to mask patterns formed in regions A to I in FIGs. 16A and 16B.
FIGs. 18A to 18I are views illustrating the Josephson junction devices formed in the regions A to I in FIGs. 16A and 16B.
FIGs. 19A to 19I are plan views illustrating mask patterns formed on a mask layer in a method for manufacturing a Josephson junction device according to a third embodiment.
FIG. 20A is a circuit diagram of a qubit according to a fourth embodiment, and FIG. 20B is a plan view of the qubit according to the fourth embodiment.

### DESCRIPTION OF EMBODIMENTS

Hereinafter, embodiments of the present invention will be described with reference to the drawings.

### [First Embodiment]

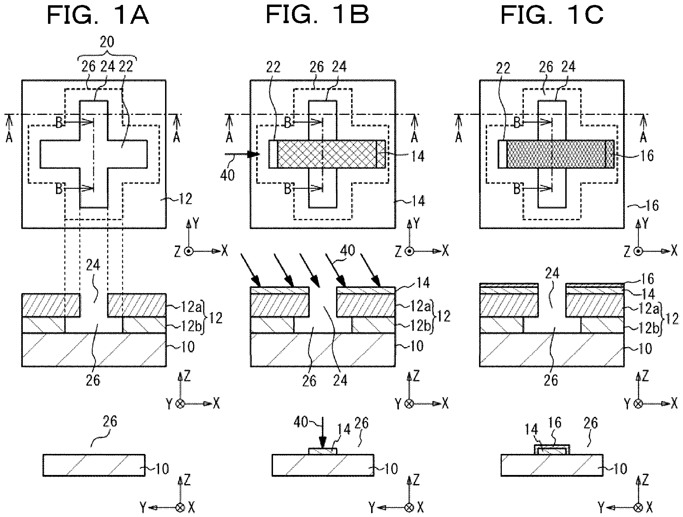

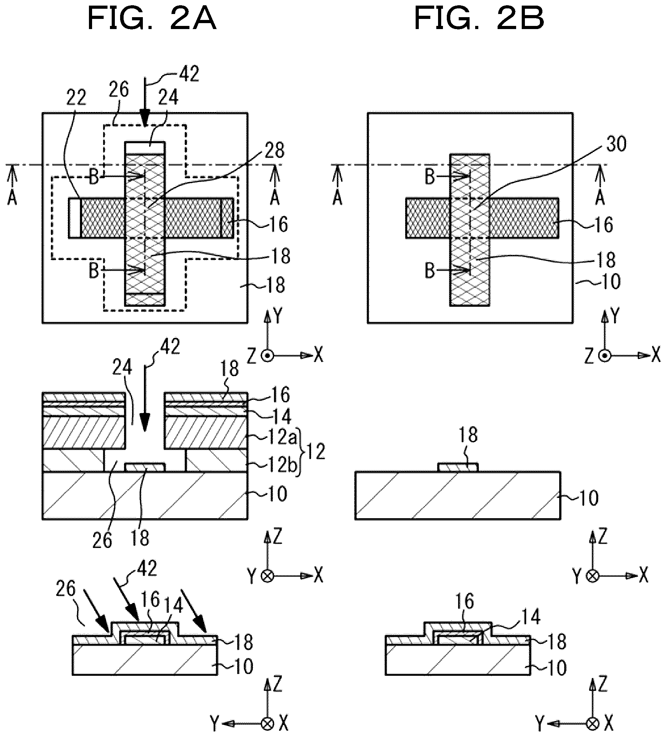

A method for manufacturing a Josephson junction device referred to as a Manhattan type will be described. First, a method for manufacturing a Josephson junction device according to a comparative example will be described. FIGs. 1A to 2B are views illustrating the method for manufacturing the Josephson junction device according to the comparative example. Upper views of FIGs. 1A to 2B are plan views illustrating the method for manufacturing the Josephson junction device according to the comparative example. Middle views are cross-sectional views taken along a line A-A of the upper views, and lower views are cross-sectional views taken along a line B-B of the upper views. In the upper plan views of FIGs. 1B to 2B, a first superconducting film 14, an insulating film 16, and a second superconducting film 18 formed in a gap 26 are hatched for clarity of the drawings (the same applies to the following similar drawings).

As in FIG. 1A, a mask layer 12 is formed on a substrate 10. The mask layer 12 has an upper layer 12a and a lower layer 12b. A mask pattern 20 including an opening 22, an opening 24, and the gap 26 is formed in the mask layer 12. The opening 22 extends in an X-axis direction, the opening 24 intersects the opening 22 and extends in a Y-axis direction, and both are formed in the upper layer 12a. The gap 26 is formed in the lower layer 12b. The gap 26 is positioned below the openings 22 and 24, and has a shape obtained by enlarging shapes of the openings 22 and 24 in plan view.

As in FIG. 1B, the first superconducting film 14 is formed above the substrate 10 by film formation from obliquely above in a -X direction as indicated by an arrow 40, using the mask layer 12 as a mask. For example, the first superconducting film 14 is formed by an oblique vacuum deposition method. Since the first superconducting film 14 is formed above the substrate 10 by film formation from obliquely above in the -X direction, by setting a width dimension of the opening 24 to an appropriate size, the first superconducting film 14 extending in the Y-axis direction is not formed in the gap 26. Only the first superconducting film 14 extending in the X-axis direction is formed in the gap 26.

As in FIG. 1C, while maintaining a vacuum state when the first superconducting film 14 is formed, oxygen is introduced into a chamber to oxidize a surface of the first superconducting film 14, and the insulating film 16 is formed at the surface of the first superconducting film 14.

As in FIG. 2A, the second superconducting film 18 is formed above the substrate 10 by film formation from obliquely above in a +Y direction as indicated by an arrow 42, using the mask layer 12 as a mask. For example, the second superconducting film 18 is formed by the oblique vacuum deposition method. Since the second superconducting film 18 is formed above the substrate 10 by film formation from obliquely above in the +Y direction, by setting a width dimension of the opening 22 to an appropriate size, the second superconducting film 18 extending in the X-axis direction is not formed in the gap 26. Only the second superconducting film 18 extending in the Y-axis direction is formed in the gap 26. Therefore, a region 28 in which the first superconducting film 14 extending in the X-axis direction and the second superconducting film 18 extending in the Y-axis direction overlap each other via the insulating film 16 is formed.

As in FIG. 2B, the mask layer 12, and the first superconducting film 14, the insulating film 16, and the second superconducting film 18 formed above the mask layer 12 are removed by a lift-off method. The region 28 in which the first superconducting film 14 extending in the X-axis direction and the second superconducting film 18 extending in the Y-axis direction overlap each other via the insulating film 16 becomes a Josephson junction 30.

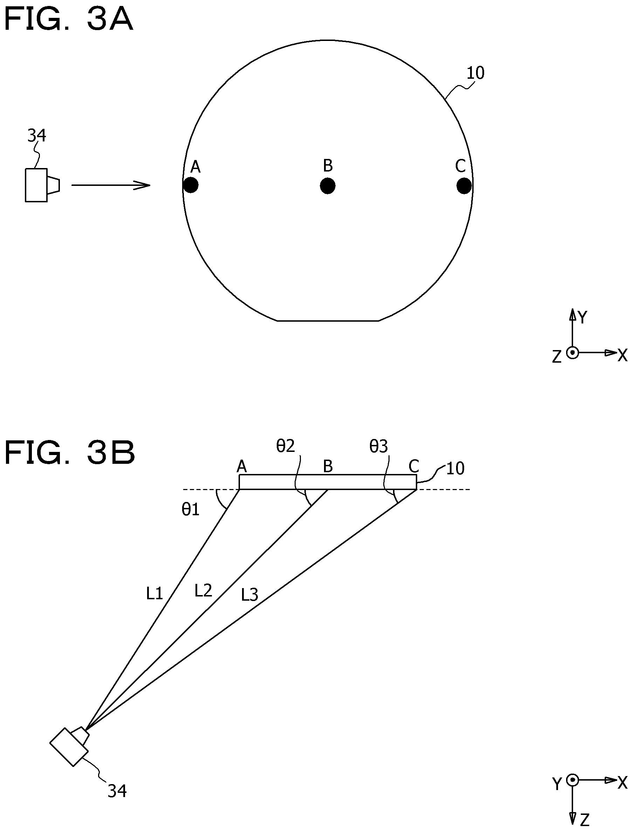

With reference to FIGs. 3A to 5C, problems caused by the method for manufacturing the Josephson junction device according to the comparative example will be described. FIGs. 3A and 3B are diagrams illustrating the oblique vacuum deposition method for film formation of the first superconducting film 14 in the method for manufacturing the Josephson junction device according to the comparative example. As in FIGs. 3A and 3B, a deposition material of a deposition source 34 is vaporized or sublimated to adhere the deposition material to the substrate 10, thereby forming the first superconducting film 14. At this time, by inclining the wafer-like substrate 10 relative to the deposition source 34, the deposition material of the deposition source 34 is made incident to the substrate 10 from obliquely above in the -X direction.

In a case where the substrate 10 is inclined relative to the deposition source 34, a distance from the deposition source 34 to the substrate 10 greatly varies in a plane of the substrate 10. In other words, a distance L2 from the deposition source 34 to a central portion B of the substrate 10, a distance L1 from the deposition source 34 to an end A of the substrate 10 closer to the deposition source 34, and a distance L3 from the deposition source 34 to an end C of the substrate 10 farther from the deposition source 34 are different. The distance L1 is shorter than the distance L2, and the distance L2 is shorter than the distance L3. As an example, it is assumed that the substrate 10 is a 3-inch (76 mm) wafer, an angle θ2 at which the deposition material of the deposition source 34 is incident to the central portion B of the substrate 10 is 45.0°, and the distance L2 is 550 mm. In this case, an angle θ1 at which the deposition material is incident to the end A of the substrate 10 closer to the deposition source 34 is 47.9°, and the distance L1 is 524 mm. An angle θ3 at which the deposition material is incident to the end C of the substrate 10 farther from the deposition source 34 is 42.3°, and the distance L3 is 577 mm.

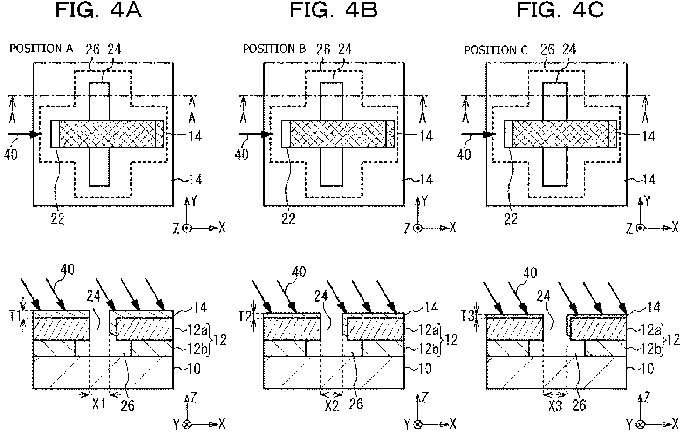

FIGs. 4A to 4C are views illustrating a film thickness distribution of the first superconducting film 14 in the method for manufacturing the Josephson junction device according to the comparative example. Upper views of FIGs. 4A to 4C are plan views of the mask patterns 20 formed at the respective positions A to C in FIGs. 3A and 3B. Lower views are cross-sectional views taken along a line A-A of the upper views. As in FIGs. 4A to 4C, since a distance from the deposition source 34 to each of the positions A to C is different, a thickness of the first superconducting film 14 deposited at each of the positions A to C is different. The closer the distance from the deposition source 34 is, the thicker the deposited first superconducting film 14 becomes, and the farther the distance is, the thinner the deposited first superconducting film 14 becomes. Therefore, a thickness T1 of the first superconducting film 14 deposited on the mask layer 12 at the position A is thicker than a thickness T2 of the first superconducting film 14 deposited on the mask layer 12 at the position B. The thickness T2 of the first superconducting film 14 deposited on the mask layer 12 at the position B is thicker than a thickness T3 of the first superconducting film 14 deposited on the mask layer 12 at the position C. As an example, in FIG. 3B, it is assumed that the distances L1, L2, and L3 are 524 mm, 550 mm, and 577 mm, and the angles θ1, θ2, and θ3 are 47.9°, 45.0°, and 42.3°. In this case, when the thickness T2 of the first superconducting film 14 at the position B is set to 28.3 nm, the thickness T1 of the first superconducting film 14 at the position A is 31.1 nm, and the thickness T3 of the first superconducting film 14 at the position C is 25.6 nm.

The first superconducting film 14 is deposited not only on an upper surface of the mask layer 12 but also on a side surface of the mask layer 12 in the opening 24. A thickness of the first superconducting film 14 on the side surface of the mask layer 12 in the opening 24 at the position A is larger than a thickness of the first superconducting film 14 on the side surface of the mask layer 12 in the opening 24 at the position B. The thickness of the first superconducting film 14 on the side surface of the mask layer 12 in the opening 24 at the position B is larger than a thickness of the first superconducting film 14 on the side surface of the mask layer 12 in the opening 24 at the position C. Therefore, when it is assumed that widths of the openings 24 formed at the respective positions A to C excluding the first superconducting films 14 are X1, X2, and X3, the width X1 is narrower than the width X2, and the width X2 is narrower than the width X3.

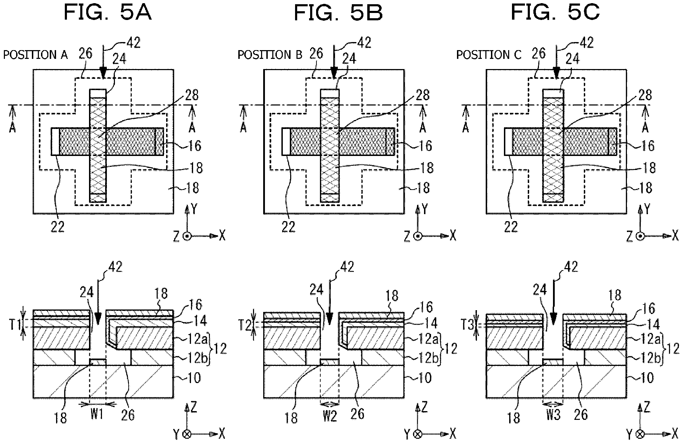

FIGs. 5A to 5C are views illustrating a width distribution of the second superconducting film 18 in the method for manufacturing the Josephson junction device according to the comparative example. Upper views of FIGs. 5A to 5C are plan views of the mask patterns 20 formed at the respective positions A to C in FIGs. 3A and 3B. Lower views are cross-sectional views taken along a line A-A of the upper views. As illustrated in FIGs. 4A to 4C, the width X1 of the opening 24 at the position A is narrower than the width X2 of the opening 24 at the position B, and the width X2 of the opening 24 at the position B is narrower than the width X3 of the opening 24 at the position C. Therefore, as in FIGs. 5A to 5C, a width W1 of the second superconducting film 18 formed in the gap 26 at the position A is narrower than a width W2 of the second superconducting film 18 formed in the gap 26 at the position B. The width W2 of the second superconducting film 18 formed in the gap 26 at the position B is narrower than a width W3 of the second superconducting film 18 formed in the gap 26 at the position C. In this manner, the width dimension of the second superconducting film 18 formed in the gap 26 varies at each of the positions A to C. Therefore, an area of the region 28 where the first superconducting film 14 and the second superconducting film 18 overlap each other via the insulating film 16 (in other words, the Josephson junction 30) varies.

Since a reciprocal of the area of the Josephson junction 30 corresponds to a junction resistance of the Josephson junction 30, characteristics of the Josephson junction device are affected by the area of the Josephson junction 30. For example, in a qubit using a transmon in which the Josephson junction device and a capacitor are coupled in parallel, when variation occurs in the area of the Josephson junction 30, the variation is reflected in variation of the qubit and becomes a factor of lowering fidelity. Therefore, as in FIGs. 5A to 5C, when the width dimension of the second superconducting film 18 varies and the area of the Josephson junction 30 varies, the characteristics of the Josephson junction device vary, and as a result, the fidelity of the qubit is lowered. In the future, as a wafer size increases and/or a size of a qubit chip increases with integration of the qubit chips, it is considered that the variation in the width dimension of the second superconducting film 18 increases and the variation in the area of the Josephson junction 30 increases.

Thus, a method for manufacturing a Josephson junction device according to a first embodiment capable of suppressing the variation in the width dimension of the second superconducting film 18 formed in the gap 26 and suppressing the variation in the area of the Josephson junction 30 will be indicated below.

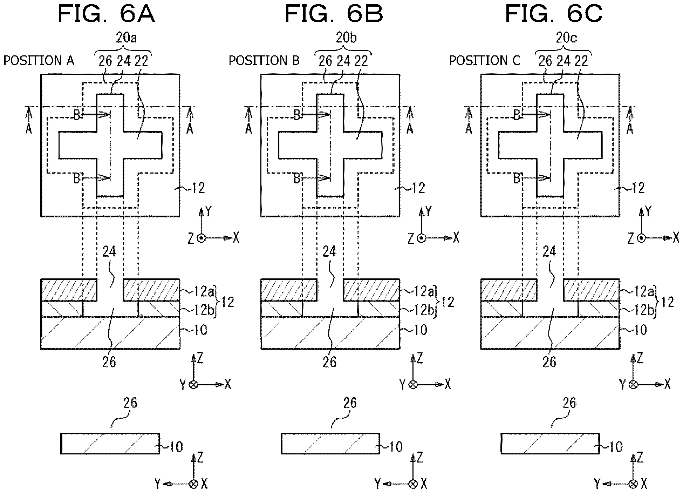

FIGs. 6A to 11C are views illustrating the method for manufacturing the Josephson junction device according to the first embodiment. Upper views of FIGs. 6A, 7A, 8A, 9A, 10A, and 11A are plan views of a mask pattern 20a formed at the position A in FIGs. 3A and 3B. Middle views are cross-sectional views taken along a line A-A of the upper views, and lower views are cross-sectional views taken along a line B-B of the upper views. Upper views of FIGs. 6B, 7B, 8B, 9B, 10B, and 11B are plan views of a mask pattern 20b formed at the position B in FIGs. 3A and 3B. Middle views are cross-sectional views taken along the line A-A of the upper views, and lower views are cross-sectional views taken along the line B-B of the upper views. Upper views of FIGs. 6C, 7C, 8C, 9C, 10C, and 11C are plan views of a mask pattern 20c formed at the position C in FIGs. 3A and 3B. Middle views are cross-sectional views taken along the line A-A of the upper views, and lower views are cross-sectional views taken along the line B-B of the upper views.

As in FIGs. 6A to 6C, the mask layer 12 is formed on the substrate 10. The substrate 10 is, for example, a high-resistance silicon substrate. The mask layer 12 has an upper layer 12a and a lower layer 12b. The mask patterns 20a to 20c each including the opening 22, the opening 24, and the gap 26 are formed at the respective positions A to C in the mask layer 12. The opening 22 extends in the X-axis direction, the opening 24 intersects (for example, is orthogonal to) the opening 22 and extends in the Y-axis direction, and both are formed in the upper layer 12a. In this manner, the mask patterns 20a to 20c have the cross-shaped openings formed by the openings 22 and 24 in the upper layer 12a. The gap 26 is formed in the lower layer 12b. The gap 26 is positioned below the openings 22 and 24, and has the larger shape than the openings 22 and 24 in plan view. The mask layer 12 is formed of, for example, a resist. For the lower layer 12b, a resist having higher sensitivity to exposure (for example, electron beam (EB) exposure) for forming the openings 22 and 24 and the gap 26 than that of the upper layer 12a is used. Therefore, when the openings 22 and 24 are formed in the upper layer 12a, the gap 26 having the shape obtained by enlarging the shapes of the openings 22 and 24 is formed in the lower layer 12b. The mask patterns 20a to 20c formed at the respective positions A to C are formed side by side in the X direction as in FIG. 3A.

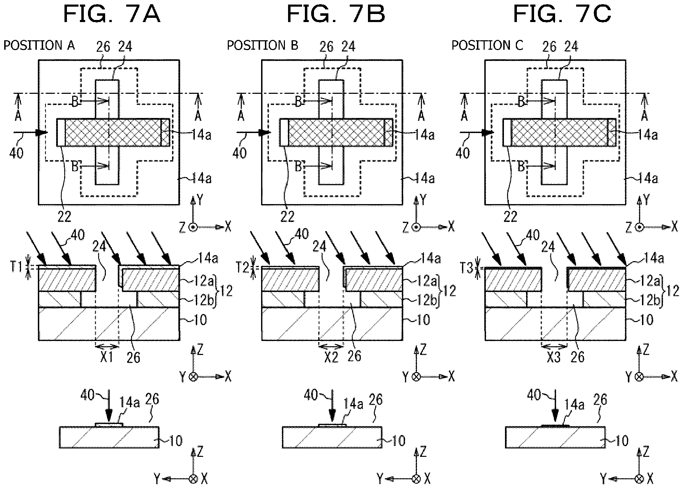

As in FIGs. 7A to 7C, a first film 14a is formed above the substrate 10 by film formation from obliquely above in the -X direction as indicated by the arrow 40, using the mask layer 12 as a mask. For example, the first film 14a is formed by the oblique vacuum deposition method. The first film 14a is, for example, an aluminum (Al) film. Since the first film 14a is formed above the substrate 10 by film formation from obliquely above in the -X direction, by setting the width dimension of the opening 24 to an appropriate size, the first film 14a extending in the Y-axis direction is not formed in the gap 26. Only the first film 14a extending in the X-axis direction is formed in the gap 26. For example, by making the width dimension of the opening 24 smaller than a thickness dimension of the upper layer 12a, it is possible to avoid that the first film 14a extending in the Y-axis direction is formed in the gap 26. The first film 14a is formed to be shifted in a +X direction relative to the opening 22. For example, film formation conditions are adjusted such that the thickness of the first film 14a formed at the position B is about half of the thickness of the first superconducting film 14 to be formed at the position B.

Since the first film 14a is formed by film formation from obliquely above in the -X direction, a distance from the deposition source 34 is such that the first film 14a formed at the position A is closer than the first film 14a formed at the position B and the first film 14a formed at the position B is closer than the first film 14a formed at the position C. Therefore, the thickness of the first film 14a formed at the position A is larger than the thickness of the first film 14a formed at the position B. The thickness of the first film 14a formed at the position B is larger than the thickness of the first film 14a formed at the position C. In this manner, a film thickness distribution is generated in the first film 14a formed at each of the positions A to C. At this stage, the width X1 of the opening 24 excluding the first film 14a at the position A is smaller than the width X2 of the opening 24 excluding the first film 14a at the position B. The width X2 of the opening 24 excluding the first film 14a at the position B is smaller than the width X3 of the opening 24 excluding the first film 14a at the position C.

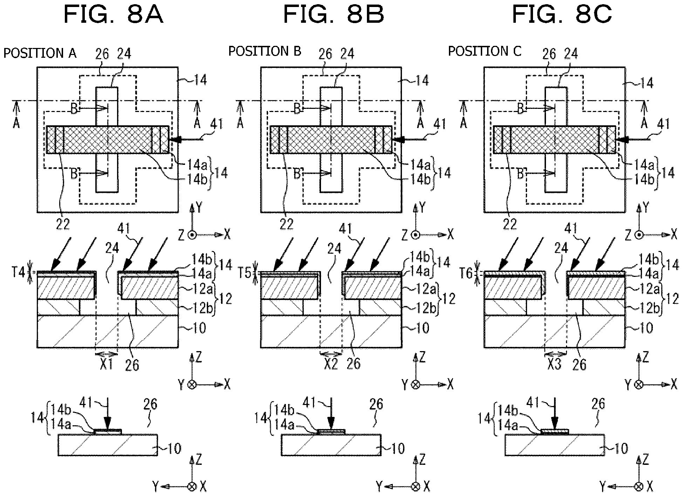

As in FIGs. 8A to 8C, a second film 14b is formed above the substrate 10 by film formation from obliquely above in the +X direction as indicated by an arrow 41, using the mask layer 12 as a mask. For example, the second film 14b is formed by the oblique vacuum deposition method. The second film 14b is, for example, an aluminum (Al) film. Since the second film 14b is formed above the substrate 10 by film formation from obliquely above in the +X direction, by setting the width dimension of the opening 24 to an appropriate size, the second film 14b extending in the Y-axis direction is not formed in the gap 26. Only the second film 14b extending in the X-axis direction is formed in the gap 26. For example, by making the width dimension of the opening 24 smaller than the thickness dimension of the upper layer 12a, it is possible to avoid that the second film 14b extending in the Y-axis direction is formed in the gap 26. The second film 14b is formed to be shifted in the -X direction relative to the opening 22. Film formation conditions are adjusted such that a film thickness of the second film 14b formed at the position B is about half of the film thickness of the first superconducting film 14 to be formed at the position B.

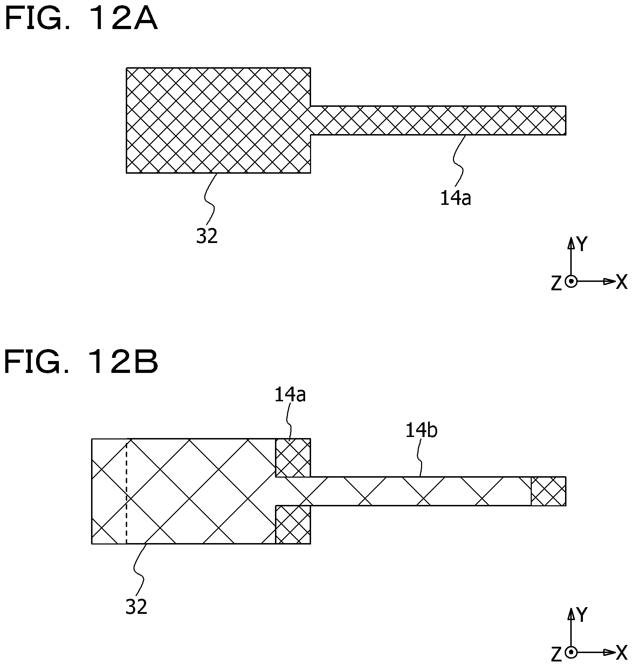

The second film 14b is formed so as to largely overlap the first film 14a, and the first superconducting film 14 is formed by the first film 14a and the second film 14b. The first superconducting film 14 has, for example, a width of about 100 nm to 300 nm, and the thickness of about 10 nm to 100 nm. Here, a pattern shift between the first film 14a and the second film 14b will be described in detail with reference to the drawings. FIG. 12A is a plan view after film formation of the first film 14a, and FIG. 12B is a plan view after film formation of the second film 14b. In FIGs. 12A and 12B, a lead pad 32 formed by the first film 14a and the second film 14b is also illustrated. As in FIGs. 12A and 12B, since the first film 14a is formed to be shifted in the +X direction relative to the opening 22 (not illustrated in FIGs. 12A and 12B), and the second film 14b is formed to be shifted in the -X direction relative to the opening 22, the first film 14a and the second film 14b are formed to be shifted in pattern in the X-axis direction.

As in FIGs. 8A to 8C, since the second film 14b is formed by film formation from obliquely above in the +X direction, a distance from the deposition source 34 is such that the second film 14b formed at the position C is closer than the second film 14b formed at the position B and the second film 14b formed at the position B is closer than the second film 14b formed at the position A. Therefore, the thickness of the second film 14b formed at the position C is larger than the thickness of the second film 14b formed at the position B. The thickness of the second film 14b formed at the position B is larger than the thickness of the second film 14b formed at the position A. In this manner, the second films 14b formed at the respective positions A to C have a film thickness distribution opposite to that of the first films 14a formed at the respective positions A to C.

Since the film thickness distribution of the first film 14a is opposite to the film thickness distribution of the second film 14b, a total film thickness of the first film 14a and the second film 14b formed at each of the positions A to C has small variation. In other words, the variation in the thickness of the first superconducting film 14 formed at each of the positions A to C is reduced. Therefore, variation among the width X1 of the opening 24 excluding the first superconducting film 14 at the position A, the width X2 of the opening 24 excluding the first superconducting film 14 at the position B, and the width X3 of the opening 24 excluding the first superconducting film 14 at the position C is reduced.

It is preferable that the thickness of the first film 14a and the thickness of the second film 14b are substantially the same in the central portion B of the substrate 10 from a viewpoint of suppressing the variation in the thickness of the first superconducting film 14 formed at each of the positions A to C using the film thickness distribution of the first film 14a and the film thickness distribution of the second film 14b. For example, in the first embodiment, for the first film 14a and the second film 14b formed at the position B, a ratio of a difference between the thickness of the first film 14a and the thickness of the second film 14b to the thickness of the first film 14a is set to ±3% or less.

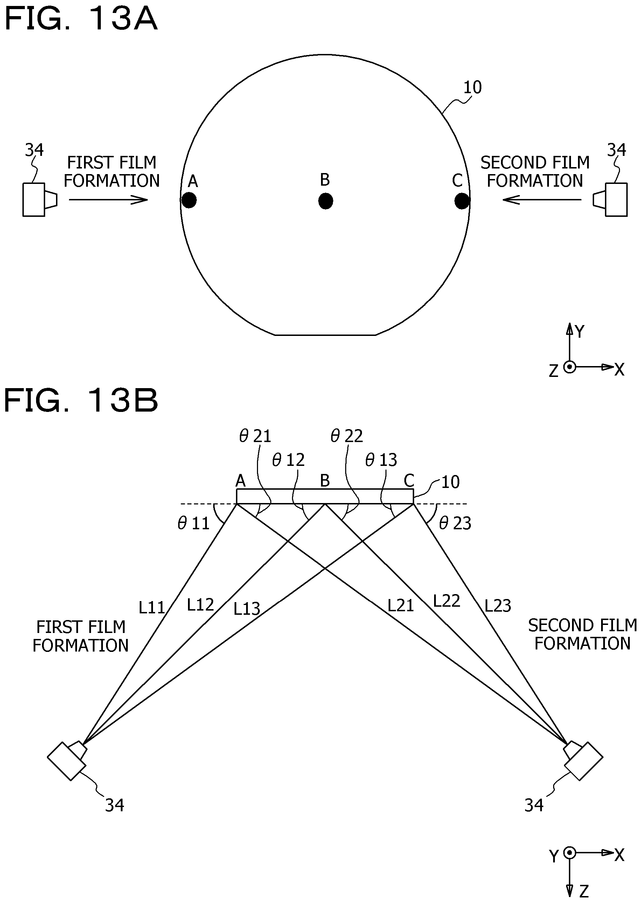

Here, the vacuum deposition method for film formation of the first superconducting film 14 including the first film 14a and the second film 14b will be described with reference to the drawings. FIGs. 13A and 13B are diagrams illustrating the oblique vacuum deposition method for film formation of the first superconducting film 14 in the method for manufacturing the Josephson junction device according to the first embodiment. As in FIGs. 13A and 13B, by inclining the substrate 10 relative to the deposition source 34, the first film 14a is formed above the substrate 10 by first film formation in which the deposition material of the deposition source 34 is made incident to the substrate 10 from obliquely above in the -X direction. Thereafter, by inclining the substrate 10 in an opposite direction relative to the deposition source 34, the second film 14b is formed above the substrate 10 by second film formation in which the deposition material is made incident to the substrate 10 from obliquely above in the +X direction.

In the first film formation, an angle at which the deposition material of the deposition source 34 is incident to the end A of the substrate 10 is defined as θ11, and a distance from the deposition source 34 to the end A of the substrate 10 is defined as L11. An angle at which the deposition material of the deposition source 34 is incident to the central portion B of the substrate 10 is defined as θ12, and a distance from the deposition source 34 to the central portion B of the substrate 10 is defined as L12. An angle at which the deposition material of the deposition source 34 is incident to the end C of the substrate 10 is defined as θ13, and a distance from the deposition source 34 to the end C of the substrate 10 is defined as L13. Furthermore, in the second film formation, an angle at which the deposition material of the deposition source 34 is incident to the end A of the substrate 10 is defined as θ21, and a distance from the deposition source 34 to the end A of the substrate 10 is defined as L21. An angle at which the deposition material of the deposition source 34 is incident to the central portion B of the substrate 10 is defined as θ22, and a distance from the deposition source 34 to the central portion B of the substrate 10 is defined as L22. An angle at which the deposition material of the deposition source 34 is incident to the end C of the substrate 10 is defined as θ23, and a distance from the deposition source 34 to the end C of the substrate 10 is defined as L23.

As an example, it is assumed that the substrate 10 is a 3-inch wafer. In the first film formation, it is assumed that the angle θ12 at which the deposition material of the deposition source 34 is incident to the central portion B of the substrate 10 is 45.0°, and the distance L12 is 550 mm. In this case, the angle θ11 at which the deposition material is incident to the end A of the substrate 10 is 47.9°, and the distance L11 is 524 mm. The angle θ13 at which the deposition material is incident to the end C of the substrate 10 is 42.3°, and the distance L13 is 577 mm. In the second film formation, it is assumed that the angle θ22 at which the deposition material of the deposition source 34 is incident to the central portion B of the substrate 10 is 45.0°, and the distance L22 is 550 mm. In this case, the angle θ21 at which the deposition material is incident to the end A of the substrate 10 is 42.3°, and the distance L21 is 577 mm. The angle θ23 at which the deposition material is incident to the end C of the substrate 10 is 47.9°, and the distance L23 is 524 mm.

For example, the thickness T2 of the first film 14a deposited on the central portion B of the substrate 10 is set to 14.2 nm. In this case, the thickness T1 of the first film 14a deposited on the end A of the substrate 10 is about 15.6 nm, and the thickness T3 of the first film 14a deposited on the end C of the substrate 10 is about 12.8 nm (see FIGs. 7A to 7C for the thicknesses T1 to T3). Furthermore, a thickness T4 of the second film 14b deposited on the central portion B of the substrate 10 is set to 14.2 nm. In this case, a thickness T5 of the second film 14b deposited on the end A of the substrate 10 is about 12.8 nm, and a thickness T6 of the second film 14b deposited on the end C of the substrate 10 is about 15.6 nm (see FIGs. 8A to 8C for the thicknesses T4 to T6). Therefore, at each of the positions A to C, a thickness of a laminated film of the first film 14a and the second film 14b, in other words, the thickness of the first superconducting film 14 is about 28.3 nm, and the variation in the thickness of the first superconducting film 14 is reduced.

The thickness of the first film 14a and the thickness of the second film 14b are somewhat affected by the incident angle at which the deposition material of the deposition source 34 is incident to the substrate 10, but are generally determined by the distance from the deposition source 34 to the substrate 10. Therefore, in order to make the thicknesses of the first film 14a and the second film 14b at the central portion B of the substrate 10 substantially the same, the distance L12 from the deposition source 34 to the central portion B in the first film formation and the distance L22 from the deposition source 34 to the central portion B in the second film formation are preferably substantially the same. For example, in the first embodiment, a ratio of a difference between the distance L12 and the distance L22 to the distance L12 is set to ±5% or less. Furthermore, when the incident angle of the deposition material from the deposition source 34 to the substrate 10 greatly changes, the thickness of the deposited film may change. Therefore, in order to make the thicknesses of the first film 14a and the second film 14b at the central portion B of the substrate 10 substantially the same, it is preferable that the incident angle θ12 of the deposition material to the central portion B in the first film formation and the incident angle θ22 of the deposition material to the central portion B in the second film formation are not greatly different. For example, in the first embodiment, a ratio of a difference between the incident angle θ12 and the incident angle θ22 to the incident angle θ12 is set to ±30% or less.

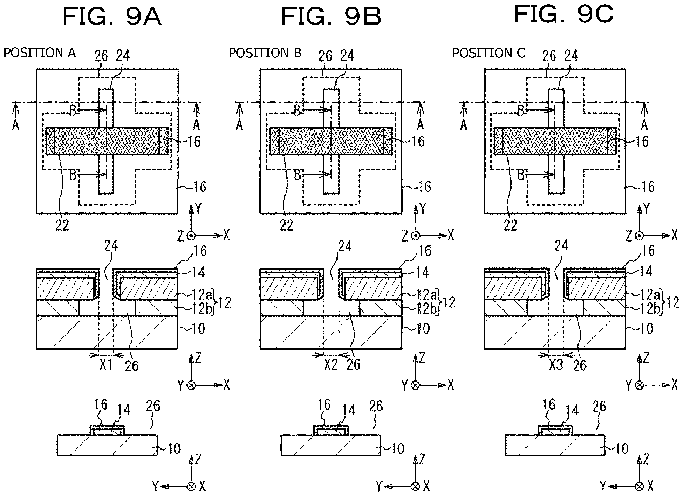

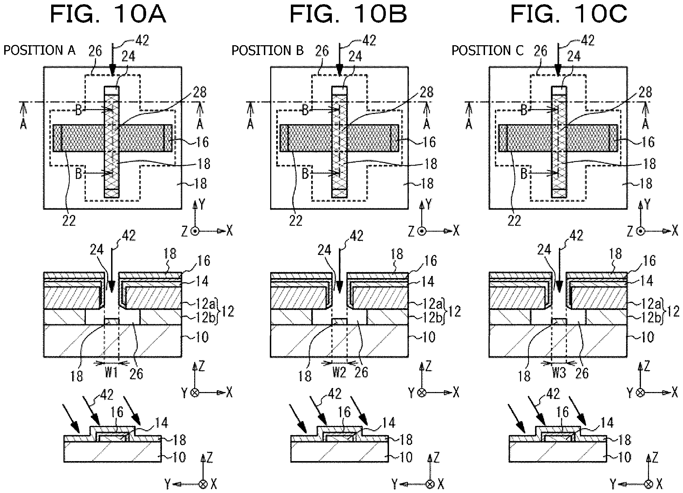

As in FIGs. 9A to 9C, while maintaining the vacuum state when the first superconducting film 14 is formed, oxygen is introduced into the chamber to oxidize the surface of the first superconducting film 14, and the insulating film 16 is formed at the surface of the first superconducting film 14. The widths X1 to X3 of the openings 24 at the respective positions A to C are narrowed by a thickness of the insulating film 16, but the variation remains small. Note that, in FIGs. 9A to 9C, the first superconducting film 14 is illustrated while omitting illustration of the first film 14a and the second film 14b (the same applies to FIGs. 10A to 11C).

As in FIGs. 10A to 10C, the second superconducting film 18 is formed above the substrate 10 by film formation from obliquely above in the +Y direction as indicated by the arrow 42, using the mask layer 12 as a mask. For example, the second superconducting film 18 is formed by the oblique vacuum deposition method. The second superconducting film 18 is, for example, an aluminum (AI) film. The second superconducting film 18 has, for example, the width of about 100 nm to 300 nm, and a thickness of about 10 nm to 100 nm. Since the second superconducting film 18 is formed above the substrate 10 by film formation from obliquely above in the +Y direction, by setting the width dimension of the opening 22 to an appropriate size, the second superconducting film 18 extending in the X-axis direction is not formed in the gap 26. Only the second superconducting film 18 extending in the Y-axis direction is formed in the gap 26. For example, by making the width dimension of the opening 22 smaller than the thickness dimension of the upper layer 12a, it is possible to avoid that the second superconducting film 18 extending in the X-axis direction is formed in the gap 26. The second superconducting film 18 is formed to be shifted in a -Y direction relative to the opening 24. Therefore, the region 28 in which the first superconducting film 14 extending in the X-axis direction and the second superconducting film 18 extending in the Y-axis direction overlap each other via the insulating film 16 is formed.

Since the variation in the widths X1 to X3 of the openings 24 at the respective positions A to C (see FIGs. 9A to 9C) is small, variation in the widths W1 to W3 of the second superconducting films 18 formed in the gaps 26 at the respective positions A to C is small.

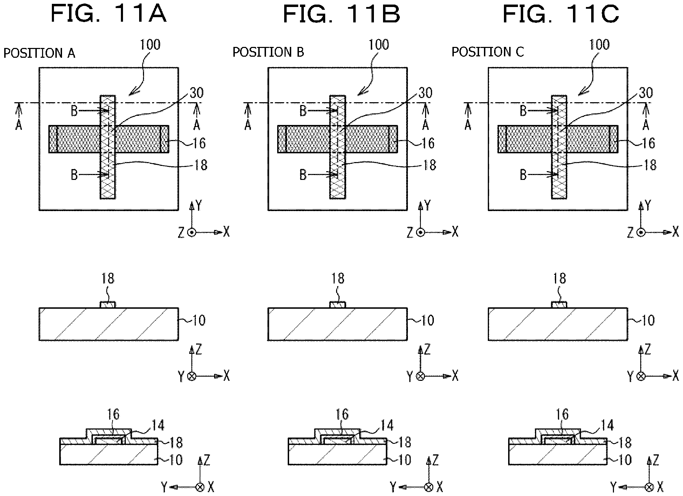

As in FIGs. 11A to 11C, the mask layer 12, and the first superconducting film 14, the insulating film 16, and the second superconducting film 18 formed above the mask layer 12 are removed by the lift-off method. The region 28 in which the first superconducting film 14 extending in the X-axis direction and the second superconducting film 18 extending in the Y-axis direction overlap each other via the insulating film 16 becomes the Josephson junction 30, and a plurality of Josephson junction devices 100 is formed on the substrate 10. The insulating film 16 has the thickness with which a tunnel effect may be obtained at a temperature at which superconduction occurs. Since the variation in the widths W1 to W3 of the second superconducting films 18 formed at the respective positions A to C is small, the variation in the area of the Josephson junction 30 is also small.

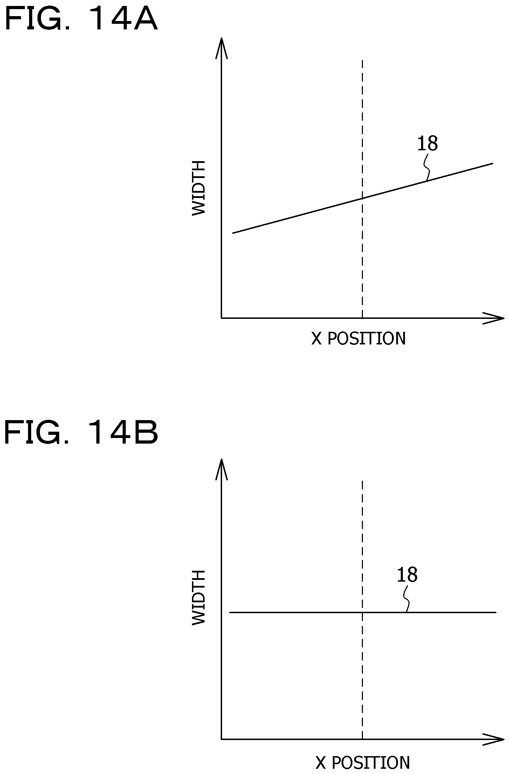

FIG. 14A is a schematic diagram illustrating the width distribution of the second superconducting film 18 in the method for manufacturing the Josephson junction device according to the comparative example, and FIG. 14B is a schematic diagram illustrating a width distribution of the second superconducting film 18 in the method for manufacturing the Josephson junction device according to the first embodiment. In FIGs. 14A and 14B, a horizontal axis indicates a position of the substrate 10 in the X-axis direction, and a vertical axis indicates the width dimension of the second superconducting film 18. As in FIG. 14A, in the case of using the method for manufacturing the Josephson junction device according to the comparative example, the width dimension of the second superconducting film 18 varies in the X-axis direction of the substrate 10. On the other hand, as in FIG. 14B, by using the method for manufacturing the Josephson junction device according to the first embodiment, the variation in the width dimension of the second superconducting film 18 may be suppressed in the X-axis direction of the substrate 10.

As described above, according to the first embodiment, as in FIG. 6A, the mask layer 12 in which the plurality of mask patterns 20a to 20c each having the opening 22 extending in the X-axis direction and the opening 24 extending in the Y-axis direction and intersecting the opening 22 is arranged in the X-axis direction is formed on the substrate 10. As in FIGs. 7A to 7C, the first film 14a is formed above the substrate 10 by film formation from obliquely above in the -X direction, using the mask layer 12 as a mask. Thereafter, as in FIGs. 8A to 8C, the second film 14b is formed above the substrate 10 by film formation from obliquely above in the +X direction 180° different from the direction of the film formation of the first film 14a relative to the substrate 10. Therefore, the first superconducting film 14 including the first film 14a and the second film 14b is formed. As in FIGs. 9A to 9C, the insulating film 16 is formed on the surface of the first superconducting film 14. As in FIGs. 10A to 10C, the second superconducting film 18 having the region 28 in which the second superconducting film 18 overlaps the first superconducting film 14 via the insulating film 16 above the substrate 10 by film formation from obliquely above in the +Y direction, using the mask layer 12 as a mask. Therefore, the variation in the width dimension of the second superconducting film 18 of the plurality of Josephson junction devices 100 formed above the substrate 10 may be suppressed. Therefore, the variation in the area of the Josephson junction 30 of the plurality of Josephson junction devices 100 may be suppressed.

Note that, in the first embodiment, the case where the film formation of the second film 14b is performed from obliquely above in the direction 180° different from the direction of the film formation of the first film 14a relative to the substrate 10 has been described as an example. However, the present invention is not limited to this case, and the film formation of the second film 14b may be performed from obliquely above in a direction 180° ± 5° different from the direction of the film formation of the first film 14a relative to the substrate 10.

Furthermore, according to the first embodiment, as in FIG. 13B, the distance L12 from the deposition source 34 to the central portion B of the substrate 10 in the film formation of the first film 14a (first film formation) is 95% or more and 105% or less of the distance L22 from the deposition source 34 to the central portion B of the substrate 10 in the film formation of the second film 14b (second film formation). Therefore, the variation in the thickness of the first superconducting film 14 in the substrate 10 may be suppressed by the film thickness distribution of the first film 14a and the film thickness distribution of the second film 14b. Since the variation in the thickness of the first superconducting film 14 is suppressed, the variation in the width dimension of the second superconducting film 18 of the plurality of Josephson junction devices 100 may be suppressed. From the viewpoint of suppressing the variation in the thickness of the first superconducting film 14, the distance L12 is preferably 97% or more and 103% or less, more preferably 98% or more and 102% or less, still more preferably 99% or more and 101% or less of the distance L22.

Furthermore, according to the first embodiment, as in FIG. 13B, the angle θ12 at which the deposition material of the deposition source 34 is incident to the central portion B of the substrate 10 in the film formation of the first film 14a (first film formation) is 70% or more and 130% or less of the angle θ22 at which the deposition material of the deposition source 34 is incident to the central portion B of the substrate 10 in the film formation of the second film 14b (second film formation). Therefore, the variation in the thickness of the first superconducting film 14 in the substrate 10 may be suppressed by the film thickness distribution of the first film 14a and the film thickness distribution of the second film 14b. Therefore, the variation in the width dimension of the second superconducting film 18 of the plurality of Josephson junction devices 100 may be suppressed. From the viewpoint of suppressing the variation in the thickness of the first superconducting film 14, the angle θ12 is preferably 75% or more and 125% or less, more preferably 80% or more and 120% or less, still more preferably 90% or more and 110% or less of the angle θ22.

Furthermore, in the first embodiment, the thickness of the first film 14a at the central portion B of the substrate 10 is 97% or more and 103% or less of the thickness of the second film 14b at the central portion B of the substrate 10. Therefore, the variation in the thickness of the first superconducting film 14 in the substrate 10 may be suppressed by the film thickness distribution of the first film 14a and the film thickness distribution of the second film 14b. Therefore, the variation in the width dimension of the second superconducting film 18 of the plurality of Josephson junction devices 100 may be suppressed. From the viewpoint of suppressing the variation in the thickness of the first superconducting film 14, the thickness of the first film 14a at the central portion B of the substrate 10 is preferably 98% or more and 102% or less, and more preferably 99% or more and 101% or less of the thickness of the second film 14b at the central portion B of the substrate 10.

### [Second Embodiment]

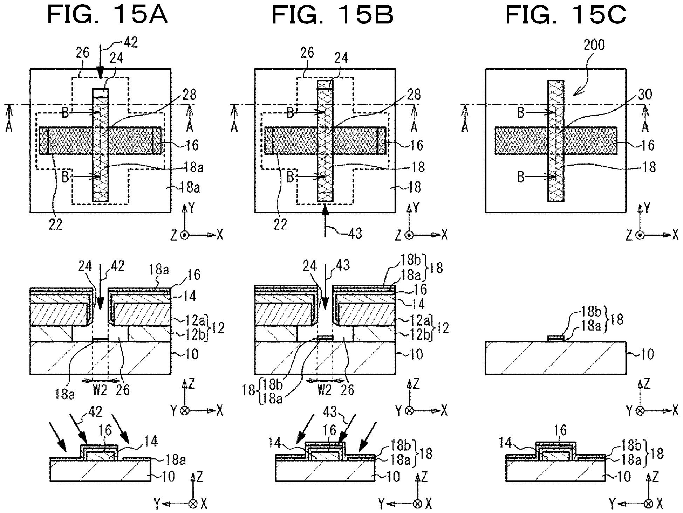

FIGs. 15A to 15C are cross-sectional views illustrating a method for manufacturing a Josephson junction device according to a second embodiment. Upper views of FIGs. 15A to 15C are plan views illustrating the method for manufacturing the Josephson junction device according to the second embodiment, middle views are cross-sectional views taken along a line A-A of the upper views, and lower views are cross-sectional views taken along a line B-B of the upper views. In the method for manufacturing the Josephson junction device according to the second embodiment, first, steps illustrated in FIGs. 6A to 9C of the first embodiment are performed. Thereafter, as in FIG. 15A, a first film 18a is formed above a substrate 10 by film formation from obliquely above in the +Y direction as indicated by an arrow 42, using a mask layer 12 as a mask. For example, the first film 18a is formed by the oblique vacuum deposition method. The first film 18a is, for example, an aluminum (Al) film. For example, film formation conditions are adjusted such that a thickness of the first film 18a formed at a center of the substrate 10 is about half of a thickness of a second superconducting film 18 to be formed at the center of the substrate 10.

Since the first film 18a is formed above the substrate 10 by film formation from obliquely above in the +Y direction, the first film 18a may not be formed on a side surface on a side of the -Y direction of a first superconducting film 14 depending on a thickness of the first superconducting film 14. Thus, as in FIG. 15B, a second film 18b is formed above the substrate 10 by film formation from obliquely above in the -Y direction as indicated by an arrow 43, using the mask layer 12 as a mask. For example, the second film 18b is formed by the oblique vacuum deposition method. The second film 18b is, for example, an aluminum (Al) film. For example, film formation conditions are adjusted such that a thickness of the second film 18b formed at the center of the substrate 10 is about half of the thickness of the second superconducting film 18 to be formed at the center of the substrate 10.

Since the second film 18b is formed above the substrate 10 by film formation from obliquely above in the -Y direction, the second film 18b is formed to cover the side surface on the side of the -Y direction of the first superconducting film 14. Note that the second film 18b may not be formed on a side surface on a side of the +Y direction of the first superconducting film 14. The second film 18b is formed so as to largely overlap the first film 18a, and the second superconducting film 18 is formed by the first film 18a and the second film 18b.

As in FIG. 15C, the mask layer 12, and the first superconducting film 14, an insulating film 16, and the second superconducting film 18 formed above the mask layer 12 are removed by the lift-off method. Therefore, a Josephson junction device 200 is formed on the substrate 10.

According to the second embodiment, after the first film 18a is formed above the substrate 10 by film formation from obliquely above in the +Y direction, the second film 18b is formed above the substrate 10 by film formation from obliquely above in the -Y direction 180° different from the direction of the film formation of the first film 18a relative to the substrate 10. Therefore, the second superconducting film 18 including the first film 18a and the second film 18b is formed. In this manner, by forming the second superconducting film 18 by film formation from obliquely above in the +Y direction and the -Y direction, it is possible to suppress disconnection from occurring in the second superconducting film 18 even in a case where the first superconducting film 14 is thick.

Note that, in the second embodiment, the case where the film formation of the second film 18b is performed from obliquely above in the direction 180° different from the direction of the film formation of the first film 18a relative to the substrate 10 has been described as an example. However, the present invention is not limited to this case, and the film formation of the second film 18b may be performed from obliquely above in a direction 180° ± 5° different from the direction of the film formation of the first film 18a relative to the substrate 10.

### [Third Embodiment]

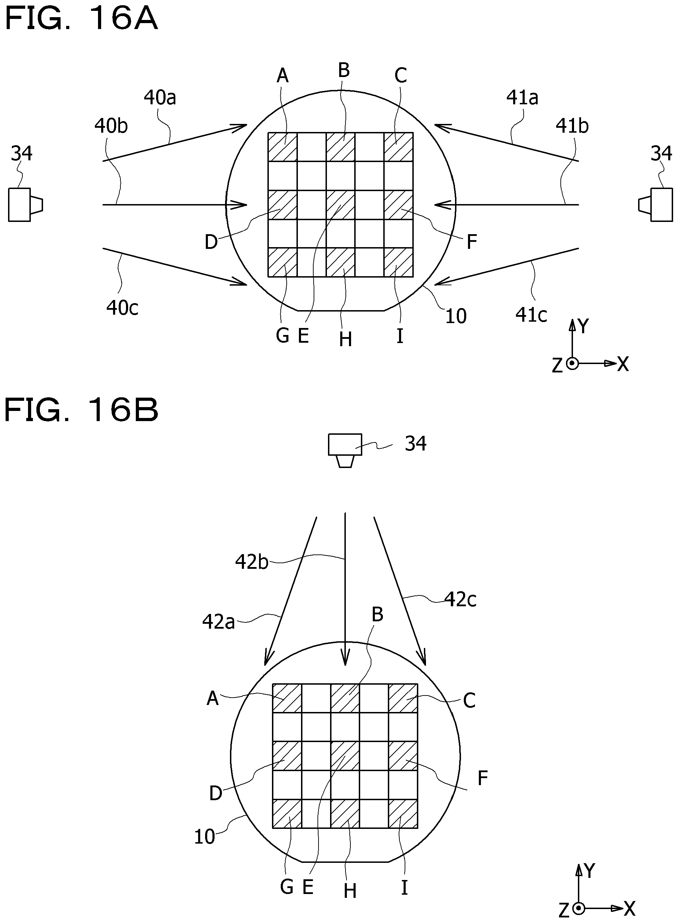

FIGs. 16A and 16B are diagrams illustrating an incident angle of a deposition material to a substrate 10 in the oblique vacuum deposition method for film formation of a first superconducting film 14 and a second superconducting film 18. As in FIG. 16A, the substrate 10 is inclined relative to a deposition source 34, and a deposition material of the deposition source 34 is made incident to the substrate 10 from obliquely above in the -X direction and the +X direction to form the first superconducting film 14. At this time, the deposition source 34 is not positioned at infinity relative to the substrate 10, but is placed at a distance of, for example, about 500 mm from the substrate 10. Therefore, as indicated by arrows 40a to 40c and arrows 41a to 41c, an incident angle of the deposition material of the deposition source 34 is different in the Y-axis direction of the substrate 10. In other words, the incident angle of the deposition material of the deposition source 34 is different in regions A, B, and C positioned on the side of the +Y direction, regions D, E, and F positioned at a center in the Y-axis direction, and regions G, H, and I positioned on the side of the -Y direction in the substrate 10.

Similarly, as in FIG. 16B, the deposition material of the deposition source 34 is made incident to the substrate 10 from obliquely above in the +Y direction to form the second superconducting film 18. Therefore, as indicated by arrows 42a to 42c, the incident angle of the deposition material of the deposition source 34 is different in the X-axis direction of the substrate 10. In other words, the incident angle of the deposition material of the deposition source 34 is different in the regions A, D, and G positioned on a side of the -X direction, the regions B, E, and H positioned at the center in the X-axis direction, and the regions C, F, and I positioned on a side of the +X direction in the substrate 10.

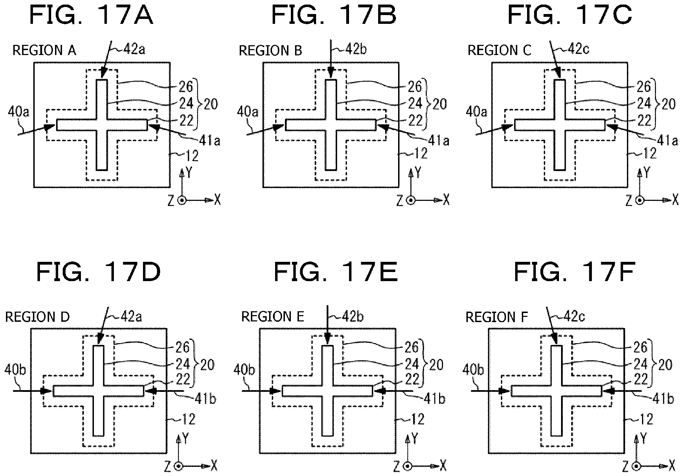

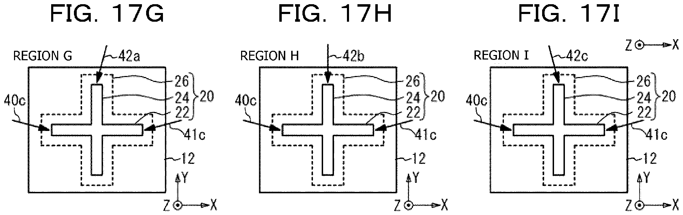

In FIGs. 17A to 17I, incident angles of the deposition material to mask patterns 20 formed in the regions A to I in FIGs. 16A and 16B are illustrated. As in FIGs. 17A to 17I, an opening 22 included in the mask pattern 20 extends in the X-axis direction and an opening 24 extends in the Y-axis direction in all of the regions A to I. Therefore, as in FIGs. 17D to 17F, with respect to the regions D, E, and F positioned at the center in the Y-axis direction in the substrate 10, the deposition material is incident to the opening 22 from directions substantially parallel to the X-axis direction as indicated by the arrows 40b and 41b. On the other hand, as in FIGs. 17A to 17C, with respect to the regions A, B, and C positioned on the side of the +Y direction in the substrate 10, the deposition material is incident to the opening 22 from directions inclined in the -Y direction relative to the opening 22 as indicated by the arrows 40a and 41a. As in FIGs. 17G to 17I, with respect to the regions G, H, and I positioned on the side of the -Y direction in the substrate 10, the deposition material is incident to the opening 22 from directions inclined in the +Y direction relative to the opening 22 as indicated by the arrows 40c and 41c.

Furthermore, as in FIGs. 17B, 17E, and 17H, with respect to the regions B, E, and H positioned at the center in the X-axis direction in the substrate 10, the deposition material is incident to the opening 24 from a direction substantially parallel to the Y-axis direction as indicated by the arrow 42b. On the other hand, as in FIGs. 17A, 17D, and 17G, with respect to the regions A, D, and G positioned on the side of the -X direction in the substrate 10, the deposition material is incident to the opening 24 from a direction inclined in the +X direction relative to the opening 24 as indicated by the arrow 42a. As in FIGs. 17C, 17F, and 17I, with respect to the regions C, F, and I positioned on the side of the +X direction in the substrate 10, the deposition material is incident to the opening 24 from a direction inclined in the -X direction relative to the opening 24 as indicated by the arrow 42c.

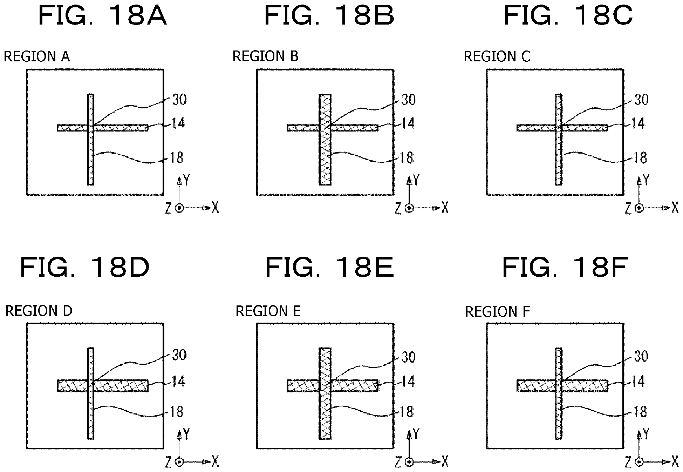

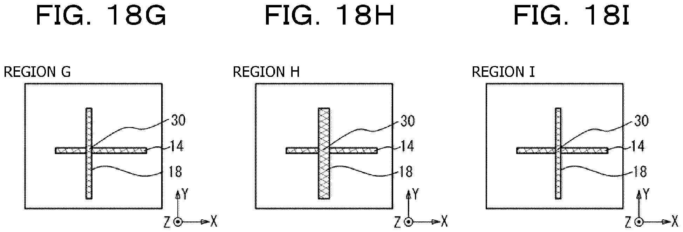

In FIGs. 18A to 18I, Josephson junction devices formed in the regions A to I in FIGs. 16A and 16B are illustrated. Note that, in FIGs. 18A to 18I, the first superconducting film 14 is illustrated through the insulating film 16. As illustrated in FIGs. 17D to 17F, in the regions D, E, and F, the deposition material is incident to the opening 22 extending in the X-axis direction from the directions substantially parallel to the X-axis direction. On the other hand, as illustrated in FIGs. 17A to 17C, in the regions A, B, and C, the deposition material is incident to the opening 22 extending in the X-axis direction from the directions inclined in the -Y direction. As illustrated in FIGs. 17G to 17I, in the regions G, H, and I, the deposition material is incident to the opening 22 extending in the X-axis direction from the directions inclined in the +Y direction. Therefore, as in FIGs. 18A to 18I, the first superconducting films 14 formed in the regions A, B, C, G, H, and I are formed to have widths narrower than widths of the first superconducting films 14 formed in the regions D, E, and F.

Furthermore, as illustrated in FIGs. 17B, 17E, and 17H, in the regions B, E, and H, the deposition material is incident to the opening 24 extending in the Y-axis direction from the direction substantially parallel to the Y-axis direction. On the other hand, as illustrated in FIGs. 17A, 17D, and 17G, in the regions A, D, and G, the deposition material is incident to the opening 24 extending in the Y-axis direction from the direction inclined in the +X direction. As illustrated in FIGs. 17C, 17F, and 17I, in the regions C, F, and I, the deposition material is incident to the opening 24 extending in the Y-axis direction from the direction inclined in the -X direction. Therefore, as in FIGs. 18A to 18I, the second superconducting films 18 formed in the regions A, C, D, F, G, and I are formed to have widths narrower than widths of the second superconducting films 18 formed in the regions B, E, and H.

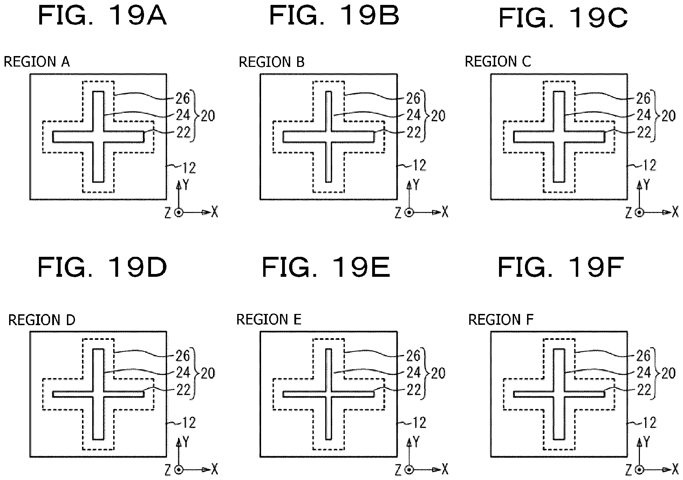

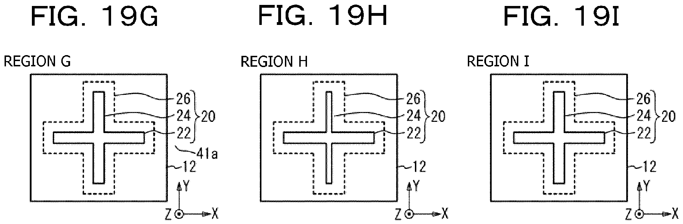

FIGs. 19A to 19I are plan views illustrating the mask patterns 20 formed in the mask layer 12 in a method for manufacturing a Josephson junction device according to the third embodiment. In FIGs. 19A to 19I, the mask patterns 20 formed in the regions A to I in FIGs. 16A and 16B are illustrated. As in FIGs. 19A to 19I, the openings 22 formed in the regions D, E, and F positioned at the center of substrate 10 in the Y-axis direction have widths narrower than widths of the openings 22 formed in the regions A, B, C, G, H, and I positioned at ends of the substrate 10 in the Y-axis direction. In this manner, in the Y-axis direction, the widths of the openings 22 positioned at the center of the substrate 10 are narrowed, and the widths of the openings 22 positioned at the ends of the substrate 10 are widened. Therefore, even in a case where the incident angles when the deposition material of the deposition source 34 is incident to the substrate 10 from obliquely above in the -X direction and the +X direction are different in the Y-axis direction, it is possible to suppress the variation in the width dimension of the first superconducting film 14 formed above the substrate 10.

Furthermore, the openings 24 formed in the regions B, E, and H positioned at the center of the substrate 10 in the X-axis direction have widths narrower than widths of the openings 24 formed in the regions A, C, D, F, G, and I positioned at the ends of the substrate 10 in the X-axis direction. In this manner, in the X-axis direction, the widths of the openings 24 positioned at the center of the substrate 10 are narrowed, and the widths of the openings 24 positioned at the ends of substrate 10 are widened. Therefore, even in a case where the incident angles when the deposition material of the deposition source 34 is incident to the substrate 10 from obliquely above in the +Y direction are different in the X-axis direction, it is possible to suppress the variation in the width dimension of the second superconducting film 18 formed above the substrate 10.

Note that, in the first to third embodiments, the case where the opening 22 and the opening 24 extend in directions different by 90° has been described as an example. However, the opening 22 and the opening 24 may extend in a direction slightly shifted from 90° (for example, 80° to 100°). Furthermore, in the first to third embodiments, the case where the first superconducting film 14 and the second superconducting film 18 are formed using the oblique deposition method has been described as an example. However, the first superconducting film 14 and the second superconducting film 18 may be formed by a method other than the oblique deposition. Furthermore, in the first to third embodiments, the case where the first superconducting film 14 and the second superconducting film 18 are aluminum (Al) films has been described as an example. However, other cases may be employed. For example, the first superconducting film 14 and the second superconducting film 18 may be a niobium (Nb) film, a niobium nitride (NbN) film, a tantalum (Ta) film, a tantalum nitride (TaN) film, or a titanium nitride (TiN) film. The case where the insulating film 16 is an oxide film of the first superconducting film 14 has been described as an example. However, other cases may be employed.

### [Fourth Embodiment]

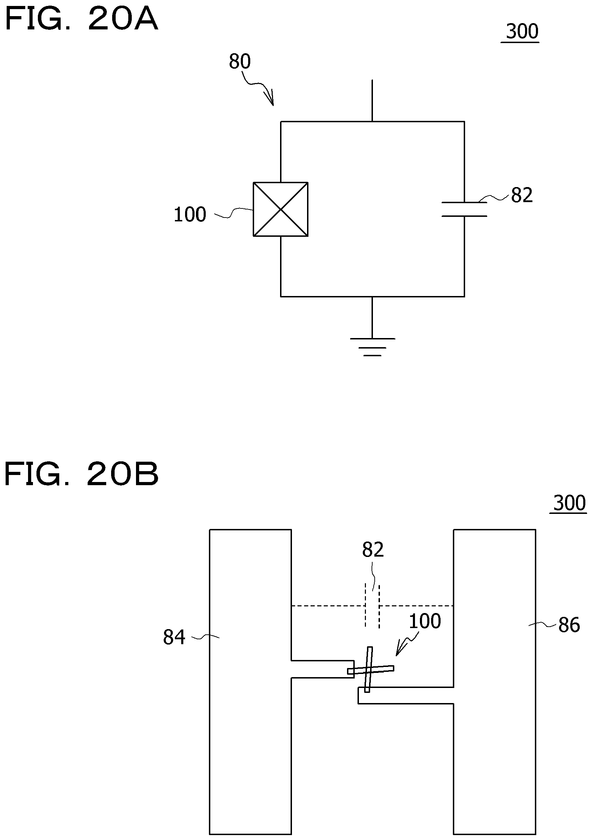

FIG. 20A is a circuit diagram of a qubit 300 according to a fourth embodiment, and FIG. 20B is a plan view of the qubit 300 according to the fourth embodiment. As in FIG. 20A, the qubit 300 according to the fourth embodiment includes a transmon 80 including a Josephson junction device 100 formed by the manufacturing method of the first embodiment and a capacitor 82 coupled in parallel to the Josephson junction device 100.

As in FIG. 20B, the Josephson junction device 100 is formed by the manufacturing method of the first embodiment, and the capacitor 82 coupled in parallel to the Josephson junction device 100 is formed. The capacitor 82 is formed between electrode films 84 and 86 coupled to the Josephson junction device 100 by making the electrode films 84 and 86 face each other, for example.

Note that, instead of the Josephson junction device 100 formed by the manufacturing method of the first embodiment, a Josephson junction device formed by the manufacturing method of the second embodiment or the third embodiment may be used.

Although the embodiments of the present invention have been described in detail above, the present invention is not limited to such specific embodiments, and various modifications and alternations may be made within the scope of the gist of the present invention described in the claims.

### CITATION LIST

### PATENT DOCUMENT

Patent Document 1: Japanese Laid-open Patent Publication No. 5-243626
Patent Document 2: U.S. Patent Application Publication No. 2022/0037578
Patent Document 3: Japanese National Publication of International Patent Application No. 2021-503171

### REFERENCE SIGNS LIST

10Substrate
12Mask layer
12aUpper layer
12bLower layer
14First superconducting film
14aFirst film
14bSecond film
16Insulating film
18Second superconducting film
18aFirst film
18bSecond film
20, 20a, 20b, 20cMask pattern
22Opening
24Opening
26Gap
28Region
30Josephson junction
32Lead pad
34Deposition source
80Transmon
82Capacitor
84Electrode film
86Electrode film
100, 200Josephson junction device

## Claims

1. A method for manufacturing a Josephson junction device, comprising:
forming, on a substrate, a mask layer in which a plurality of mask patterns, each of which has a first opening that extends in a first direction and a second opening that extends in a second direction that intersects the first direction and that intersects the first opening, is arranged in the first direction;
forming, using the mask layer as a mask, a first film above the substrate by first film formation from obliquely above in the first direction, and forming, after the forming the first film, a second film above the substrate by second film formation from obliquely above in a direction different from the direction of the first film formation relative to the substrate, and forming a first superconducting film that includes the first film and the second film;
forming an insulating film on a surface of the first superconducting film; and
forming, using the mask layer as a mask, a third film that has a region in which the third film overlaps the first superconducting film via the insulating film above the substrate by third film formation from obliquely above in the second direction, and forming a second superconducting film that includes the third film.

2. The method for manufacturing a Josephson junction device according to claim 1, wherein
the first film formation and the second film formation are oblique deposition, and
a distance from a deposition source to a center of the substrate in the first film formation is 95% or more and 105% or less of a distance from the deposition source to the center of the substrate in the second film formation.

3. The method for manufacturing a Josephson junction device according to claim 2, wherein an angle at which the deposition material is incident to the center of the substrate in the first film formation is 70% or more and 130% or less of an angle at which the deposition material is incident to the center of the substrate in the second film formation.

4. The method for manufacturing a Josephson junction device according to claim 2 or 3, wherein, in the forming the first superconducting film, the first film and the second film are formed such that a thickness of the second film at the center of the substrate is 97% or more and 103% or less of a thickness of the first film at the center of the substrate.

5. The method for manufacturing a Josephson junction device according to claim 1 or 2, wherein, in the forming the second superconducting film, after the third film is formed by the third film formation, a fourth film is formed above the substrate by fourth film formation from obliquely above in a direction different from the direction of the third film formation by 180° ± 5°, and the second superconducting film that includes the third film and the fourth film is formed.

6. The method for manufacturing a Josephson junction device according to claim 1 or 2, wherein, in the forming the mask layer, the mask layer that includes an upper layer in which the first opening and the second opening are formed and a lower layer which is positioned below the first opening and the second opening and has a larger gap than the first opening and the second opening in plan view is formed.

7. The method for manufacturing a Josephson junction device according to claim 1 or 2, wherein the second film formation is executed from a direction different from the direction of the first film formation by 180° ± 5° in plan view of a surface of the substrate.

8. A method for manufacturing a qubit, comprising:
forming a Josephson junction device; and
forming a capacitor coupled in parallel to the Josephson junction device,
wherein the forming the Josephson junction device includes:
forming, on a substrate, a mask layer in which a plurality of mask patterns, each of which has a first opening that extends in a first direction and a second opening that extends in a second direction that intersects the first direction and that intersects the first opening, is arranged in the first direction;
forming, using the mask layer as a mask, a first film above the substrate by first film formation from obliquely above in the first direction, and forming, after the forming the first film, a second film above the substrate by second film formation from obliquely above in a direction different from the direction of the first film formation relative to the substrate, and forming a first superconducting film that includes the first film and the second film;
forming an insulating film on a surface of the first superconducting film; and
forming, using the mask layer as a mask, a third film that has a region in which the third film overlaps the first superconducting film via the insulating film above the substrate by third film formation from obliquely above in the second direction, and forming a second superconducting film that includes the third film.
